# FASCICULE DE BREVET EUROPEEN

(11) **EP 1 683 217 B1**
(45) Date de publication et mention de la délivrance du brevet: **15.08.2007**
(21) Numéro de dépôt: 04805392.0
(22) Date de dépôt: 04.11.2004
(51) Int. Cl.: H01M 10/04, H01M 10/36, H01M 10/38

(54) **PROCEDE DE FABRICATION D UNE MICRO-BATTERIE AU LITHIUM**
VERFAHREN ZUR HERSTELLUNG EINER LITHIUM-MIKROBATTERIE
METHOD FOR PRODUCING A LITHIUM MICROBATTERY

(30) Priorité: 14.11.2003 FR 0313325
(43) Date de publication de la demande: 26.07.2006
(73) Titulaire: COMMISSARIAT A L'ENERGIE ATOMIQUE, 75752 Paris Cédex 15 (FR)
(72) Inventeur: GAILLARD, Frédéric, F-38500 Voiron (FR); PLISSONNIER, Marc, F-38320 Eybens (FR); SALOT, Raphael, F-38250 Lans en Vercors (FR); ROCHE, Stéphanie, F-75012 Paris (FR)
(74) Mandataire: Hecké, Gérard
(86) Numéro de dépôt international: PCT/FR2004/002842
(87) Numéro de publication internationale: WO 2005/050756

(56) Documents cités:
- WO-A-00/60689
- WO-A-02/47187
- US-A- 5 561 004
- US-A1- 2003 118 897
- US-A1- 2003 175 585
- US-B1- 6 280 875
- BATES J B ET AL: "THIN FILM RECHARGEABLE LITHIUM BATTERIES FOR IMPLANTABLE DEVICES" ASAIO JOURNAL, J.B.LIPPINCOTT CO.,HAGERSTOWN,MD, US, vol. 43, no. 5, 1 septembre 1997 (1997-09-01), pages 644-647, XP000728796 ISSN: 1058-2916

## Description

### Domaine technique de l'invention

L'invention concerne un procédé de fabrication d'une micro-batterie au lithium comportant successivement la formation, sur un substrat, de premier et second collecteurs de courant, d'une cathode, d'un électrolyte comportant un composé lithié et d'une anode comportant du lithium.

### État de la technique

Actuellement, la plupart des micro-batteries au lithium est réalisée par dépôt de couches minces à travers des masques destinés à définir la forme définitive des différents éléments constitutifs de la micro-batterie. Ainsi, dans une micro-batterie, les collecteurs de courant, la cathode et l'électrolyte sont généralement réalisés par un dépôt physique en phase vapeur (PVD ou "Physical Vapor Deposition"), sur un substrat. Les collecteurs de courant sont, par exemple, en platine tandis que la cathode peut être en disulfure de titane (TiS₂), en oxysulfure de titane (TiOₓS_{y}), en oxyde de vanadium (VₓO_{y}). L'électrolyte comporte un composé lithié tel qu'un oxynitrure de phosphore et de lithium (LiPON) et un dépôt de lithium métallique par évaporation à travers un masque permet de définir l'anode.

Cette technique de masquage est très adaptée à des dimensions centimétriques et plus. Cependant, la technique de masquage induit une contamination particulaire et le masque utilisé peut rayer la couche sur lequel il est déposé, risquant, ainsi, d'endommager fortement la micro-batterie. Enfin, lorsque la taille des composants d'une micro-batterie est réduite, le masque peut s'avérer très néfaste, notamment à cause des effets de bords qui peuvent se produire. De plus, les micro-batteries actuelles sont développées pour être incorporées dans des micro-composants utilisant tout type de technologies microélectroniques. Il est donc nécessaire que les techniques de réalisation des micro-batteries soient compatibles avec les technologies microélectroniques classiquement utilisées.

De même, avec la technologie actuelle de dépôt à travers un masque, la micro-batterie en cours de réalisation ne peut ni être placée à l'air libre, ni être déplacée entre deux étapes de dépôt car l'eau, l'air et l'humidité sont néfastes vis-à-vis des composés lithiés ou du lithium compris dans la micro-batterie. Ainsi, la mise en oeuvre du procédé de fabrication s'avère encore difficile à industrialiser, très coûteuse et n'est pas compatible avec les technologies mises en oeuvre dans le domaine de la microélectronique.

Une fois la micro-batterie au lithium fabriquée, l'anode en composé lithié étant exposée, il est également connu de déposer une enveloppe de protection sur la totalité de la micro-batterie pour protéger l'anode contre l'environnement extérieur. L'enveloppe de protection est, par exemple, formée de couches métalliques et d'une couche de parylène®. Ainsi, au cours de sa réalisation et jusqu'à l'étape finale d'encapsulation, la micro-batterie reste sous une atmosphère neutre, par exemple sous argon.

Pour remédier au problème de la sensibilité de l'anode à l'air, le document WO-A1-0060689 décrit un mode de fabrication d'une batterie au lithium dans lequel l'anode en lithium métallique est formée par un plaquage électrochimique entre le collecteur de courant anodique et une couche de recouvrement, pendant la charge initiale de la batterie. Ainsi, avant sa mise en charge initiale, la batterie ne comporte pas de matériau anodique et peut subir un traitement thermique à une température de 250°C, à l'air pendant 10 minutes, sans que la capacité de charge et de décharge ne se dégrade.

### Objet de l'invention

L'invention a pour but la fabrication d'une micro-batterie au lithium facile à mettre en oeuvre, peu coûteuse et compatible avec les technologies mises en oeuvre dans le domaine de la microélectronique, notamment pour incorporer une telle micro-batterie sur un micro-composant tel qu'un circuit intégré.

Selon l'invention, ce but est atteint par le fait que l'étape de formation de l'électrolyte comporte au moins les opérations successives suivantes :
- dépôt d'une couche mince électrolytique sur le substrat muni des collecteurs de courant et de la cathode,
- dépôt, sur la couche mince électrolytique, d'une première couche mince de protection chimiquement inerte par rapport au lithium puis d'une première couche mince de masquage,
- réalisation d'un masque par photolithographie sur la première couche mince de masquage,
- gravure sélective de la première couche mince de masquage puis retrait du masque,
- gravure sélective de la première couche mince de protection et de la couche mince électrolytique de manière à former l'électrolyte dans la couche mince électrolytique, et retrait des premières couches minces de protection et de masquage.

Selon un développement de l'invention, la première couche mince de protection est constituée par un premier matériau choisi parmi un carbure de silicium amorphe hydrogéné, un oxycarbure de silicium amorphe hydrogéné, un carbonitrure de silicium amorphe hydrogéné, du carbone amorphe hydrogéné, du carbone amorphe fluoré et hydrogéné, un nitrure de carbone amorphe fluoré et hydrogéné.

Selon un autre développement de l'invention, la première couche mince de masquage est constituée par un second matériau distinct du premier matériau et choisi parmi un carbure de silicium amorphe hydrogéné, un oxycarbure de silicium amorphe hydrogéné, un carbonitrure de silicium amorphe hydrogéné, un nitrure de silicium et un oxyde de silicium.

Selon un mode de réalisation préférentiel, la formation de l'anode comporte au moins les étapes suivantes :
dépôt d'une couche mince anodique sur le substrat muni des collecteurs de courant, de la cathode et de l'électrolyte,
dépôt d'une troisième couche mince de protection puis d'une seconde couche mince de masquage sur la couche mince anodique,
réalisation d'un masque par photolithographie sur la seconde couche mince de masquage,
gravure sélective de la seconde couche mince de masquage puis retrait du masque,
gravure sélective de la troisième couche mince de protection et de la couche mince anodique de manière à former l'anode dans la couche mince anodique et
retrait des couches minces de protection et de masquage.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
Les figures 1 à 5 représentent, en coupe, des étapes successives de fabrication de collecteurs de courant et d'une cathode sur un substrat, selon l'art antérieur.
Les figures 6 à 9 représentent, en coupe, différentes étapes de formation d'un électrolyte selon l'invention.
La figure 10 représente, en coupe, une étape d'encapsulation de l'électrolyte formé selon les figures 6 à 9.
Les figures 11 à 14 représentent, en coupe, différentes étapes de formation d'une anode selon l'invention.
La figure 15 représente, en coupe, une micro-batterie au lithium fabriquée selon l'invention.
La figure 16 représente une vue en coupe de la micro-batterie au lithium selon la figure 15, munie d'une couche de protection.
La figure 17 représente une vue en coupe de la micro-batterie au lithium selon la figure 15, munie d'une enveloppe de protection.

### Description de modes particuliers de réalisation.

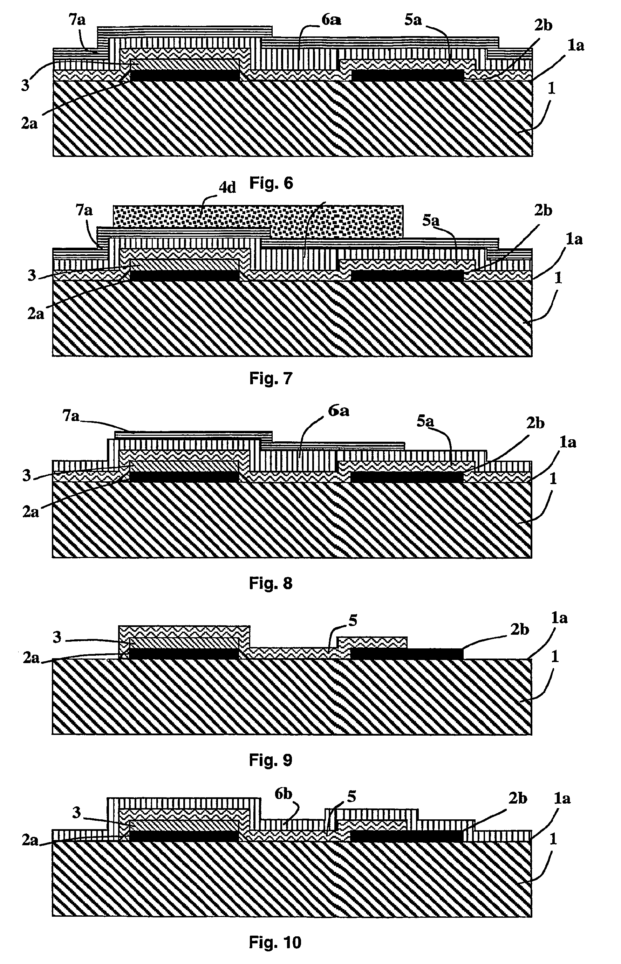

Comme illustré à la figure 5, les premières étapes de fabrication d'une micro-batterie au lithium consistent à former des premier et second collecteurs de courant 2a et 2b et une cathode 3 sur une face 1a d'un substrat 1. Les premières étapes de fabrication de la micro-batterie au lithium peuvent être réalisées par tout type de méthodes connu.

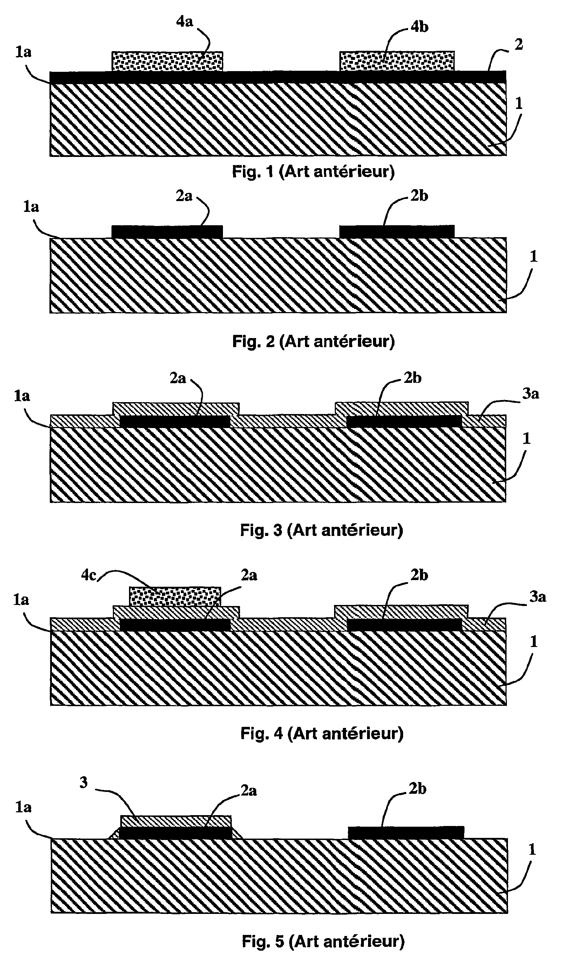

De préférence et comme représenté aux figures 1 et 2, pour former les premier et second collecteurs de courant 2a et 2b, une couche mince 2, par exemple en platine, en titane ou en or et d'une épaisseur de 200nm, est déposée sur la totalité du substrat 1 par dépôt physique en phase vapeur (PVD ou "Physical Vapor Deposition") ou par dépôt chimique en phase vapeur (CVD ou "Chemical Vapor Deposition"). Le substrat 1 peut être, par exemple, une plaque en silicium ou une plaque en silicium contenant un circuit intégré à la demande également appelé circuit ASIC ("Application Specific Integrated circuit"). La couche mince 2 est ensuite recouverte par une couche mince en résine photosensible qui est photolithographiée de manière à former des premier et second éléments de masquage 4a et 4b (figure 1). Les premier et second éléments de masquage 4a et 4b déterminent respectivement la forme et la position des premier et second collecteurs de courant 2a et 2b sur la face 1 a du substrat 1, par gravure plasma (figure 2). La gravure plasma est, par exemple, réalisée avec un mélange d'argon, d'azote et de tétrafluorure de carbone (CF₄).

La cathode 3 est ensuite formée sur le premier collecteur de courant 2a en déposant, par dépôt PVD ou CVD, une couche mince cathodique 3a d'environ 1,5µm sur la totalité de la face la du substrat 1 munie des premier et second collecteurs 2a et 2b (figure 3). Une couche mince en résine photosensible est ensuite déposée sur la totalité de la couche mince cathodique 3a, puis elle est photolithographiée pour former un troisième élément de masquage 4c (figure 4). Le troisième élément de masquage 4c disposé au-dessus du premier collecteur de courant 2a détermine la forme et la position de la cathode 3, lors d'une étape de gravure plasma (figure 5). La cathode 3 recouvrant totalement le premier collecteur de courant 2a est constituée par tout type de matériau connu à cet effet, et, à titre d'exemple, elle peut être en disulfure de titane (TiS₂), en pentoxyde de vanadium (V₂O₅) ou en oxysulfure de titane également appelé "TiOS" ou TiOₓS_{y}.

Actuellement, les éléments constitutifs de la micro-batterie au lithium contenant des composés lithiés très sensibles à l'oxygène, à l'azote et à l'eau, ne peuvent être formés avec les techniques mises en oeuvre pour réaliser les col lecteurs de courant 2a et 2b et la cathode 3 et notamment par photolithographie et par gravure. En effet, certaines étapes comme le retrait des éléments de masquage en résine et le déplacement du substrat 1 entre deux étapes de réalisation de l'élément constitutif peuvent induire une contamination particulaire et/ou une détérioration des composants lithiés. Avant de réaliser une photolithographie et une gravure par plasma, il serait possible de déposer une couche mince de protection sur la couche mince comportant le composant lithié. Une telle couche mince de protection ne serait cependant pas suffisante pour empêcher la détérioration de la couche mince en composant lithié, notamment lors du retrait des éléments de masquage.

Pour surmonter cet inconvénient, l'invention utilise un double masquage constitué de deux couches minces superposées distinctes, permettant à la fois d'utiliser les technologies de la microélectronique, notamment la photolithographie et la gravure par plasma, et d'éviter tout endommagement des couches en composé lithié. Le double masquage est constitué par des matériaux inertes vis-à-vis du lithium et permettant la gravure de la couche mince en composé lithié.

Ainsi, comme illustré aux figures 6 à 9, l'électrolyte 5 comportant au moins un composé lithié, par exemple un oxynitrure de phosphore et de lithium (LiPON), est formé sur la face 1a du substrat 1 munie des premier et second collecteurs de courant 2a et 2b et de la cathode 3. L'électrolyte 5 recouvre la totalité de l'anode 3, une partie de la face 1a du substrat 1 disposée entre les premier et second collecteurs de courant 2a et 2b et une partie du second collecteur de courant 2b (figure 9). Comme représentée à la figure 6, pour former l'électrolyte 5 et notamment définir sa forme et sa position, une couche mince électrolytique 5a, comportant au moins un composé lithié et d'une épaisseur de l'ordre de 1 µm est déposée sur la totalité de la face 1 a du substrat 1 munie des collecteurs de courant 2a et 2b et de la cathode 3. Le dépôt de la couche mince électrolytique 5a est, par exemple, un dépôt physique en phase vapeur. Pour protéger le composé lithié contenu dans la couche mince électrolytique 5a, une première couche mince de protection 6a constituée par un matériau chimiquement inerte par rapport au lithium et une première couche mince de masquage 7a sont successivement déposées sur la totalité de la couche mince électrolytique 5a, formant ainsi un empilement dit double masquage. Le double masquage est, par exemple, réalisé par dépôt chimique en phase vapeur assisté par plasma (PECVD ou "Plasma Enhanced Chemical Vapor Deposition").

La première couche de protection 6a et la première couche de masquage 7a sont, de préférence, respectivement constituées par des premier et second matériaux distincts pouvant être choisis parmi un carbure de silicium amorphe hydrogéné (SiCₓH_{y}, également noté SiCₓ:H, avec 0<x≤1), un oxycarbure de silicium amorphe hydrogéné (SiOₓC_{y}H_{z}, également noté SiOₓC_{y}:H, avec 0<x≤2 et 0<y≤1) et un carbonitrure de silicium amorphe hydrogéné (SiCₓN_{y}H_{z}, également noté SiCₓN_{y}:H, avec 0<x≤1 et 0<y≤1,33).

Le premier matériau de la première couche de protection 6a peut également être choisi parmi du carbone amorphe hydrogéné (CHₓ ou C:H), du carbone amorphe fluoré et hydrogéné également noté CFₓH_{y} ou CFₓ:H ou un nitrure de carbone amorphe fluoré et hydrogéné (CNₓF_{y}H_{z} également noté CNₓF_{y}:H). Le second matériau de la première couche de masquage 7a peut également être choisi parmi un nitrure de silicium (SiN) ou un oxyde de silicium tel que SiO₂. Du carbone amorphe hydrogéné (CHₓ ou C:H) et/ou du silicium amorphe hydrogéné (SiHₓ ou Si:H) pourraient également être utilisés comme matériaux inertes vis-à-vis du lithium car les matériaux à base de lithium ne réagissent pas avec le silicium ou le carbone. Cependant, ces deux derniers matériaux ne sont pas suffisamment imperméables pour assurer seuls l'étanchéité de la couche en matériau lithié.

La première couche de protection 6a recouvre totalement la couche mince électrolytique 5a de manière à former une encapsulation étanche de ladite couche mince électrolytique 5a tandis que la première couche mince de masquage 7a permet de réaliser une étape de photolithographie puis une gravure de la couche électrolytique 5a, sans l'endommager.

Ainsi, comme représentée à la figure 7, l'étape de photolithographie consiste à déposer une couche mince en résine photosensible sur la totalité de la couche mince de masquage 7a, puis à l'insoler à travers un masque de manière à obtenir un quatrième élément de masquage 4d en résine photosensible, une fois les parties insolées éliminées (dans le cas d'une résine photosensible positive). Le quatrième élément de masquage 4d recouvrant une partie de la première couche de masquage est disposé au-dessus de la totalité de la cathode 3, de la partie de la face 1a du substrat comprise entre les premier et second collecteurs de courant 2a et 2b et d'une partie du second collecteur de courant 2b.

La première couche de masquage 7a étant directement en contact avec l'élément de masquage en résine photosensible lors de l'étape de photolithographie et avec le plasma de gravure, elle présente des caractéristiques de gravure différentes de celles de la première couche de protection et son épaisseur est, de préférence, de l'ordre de quelques centaines de nanomètres. La première couche de masquage 7a présente également une bonne adhésion sur la première couche de protection 6a et elle peut également jouer un rôle de couche anti-réflective pour l'étape de photolithographie, en éliminant les rayons lumineux parasites qui pourraient sensiblement modifier la forme de l'élément de masquage.

Les premières couches de protection 6a et de masquage 7a ainsi que la couche mince électrolytique 5a ont un comportement différent vis-à-vis de la gravure par plasma. Ainsi, il est possible de réaliser des gravures sélectives permettant de ne pas endommager la couche électrolytique 5a lors de l'élimination du quatrième élément de masquage 4d en résine photosensible. En effet, l'él ément de masquage est généralement éliminé au moyen d'un solvant risquant d'endommager le composé lithié de la couche électrolytique si celui-ci n'était pas protégé par le double masquage. La technique de double masquage permet ainsi au matériau lithié de ne jamais être en contact avec l'environnement, et notamment grâce à la sélectivité des gravures successives.

Ainsi, comme représentée à la figure 8, la première couche de masquage 7a est gravée, de préférence par plasma, le quatrième élément de masquage 4d définissant la forme et la position de la première couche de masquage restant. En effet, seule la partie libre de la couche de masquage 7a, c'est-à-dire la partie non recouverte par le quatrième élément de masquage 4c est retirée par gravure. Puis, le quatrième élément de masquage 4d est retiré par tout type de moyen connu et notamment au moyen d'un solvant.

Comme illustré aux figures 8 et 9, l'électrolyte 5 est formé, dans la couche mince électrolytique 5a, par une gravure sélective de préférence par plasma de la première couche de protection 6a et de la couche mince électrolytique 5a. Seules les parties de la première couche de protection et de la couche mince électrolytique non recouvertes par la première couche de masquage 7a sont retirées par gravure. Ainsi, la forme et la position de l'électrolyte 5 est déterminée par la forme et la position de la première couche de masquage 7a, une fois celle-ci gravée. Les premières couches de protection 6a et de masquage 7a sont ensuite retirées.

Pour former l'anode, il peut être nécessaire de déplacer la micro-batterie au lithium en cours de réalisation et donc de la placer à l'air libre, ce qui risquerait d'endommager l'électrolyte 5 comportant un composant lithié. Dans ce cas, une seconde couche de protection 6b est déposée sur la totalité de la surface de la face 1 a du substrat 1 munie des collecteurs de courant 2a et 2b, de la cathode 3 et de l'électrolyte 5, de manière à recouvrir totalement et de manière étanche l'électrolyte 5 (figure 10). A titre d'exemple, la seconde couche de protection 6b peut être constituée par le même matériau que la première couche de protection 6a et elle peut être déposée par un dépôt PECVD. La seconde couche de protection 6b sera retirée, une fois que la micro-batterie au lithium sera replacée dans un environnement neutre.

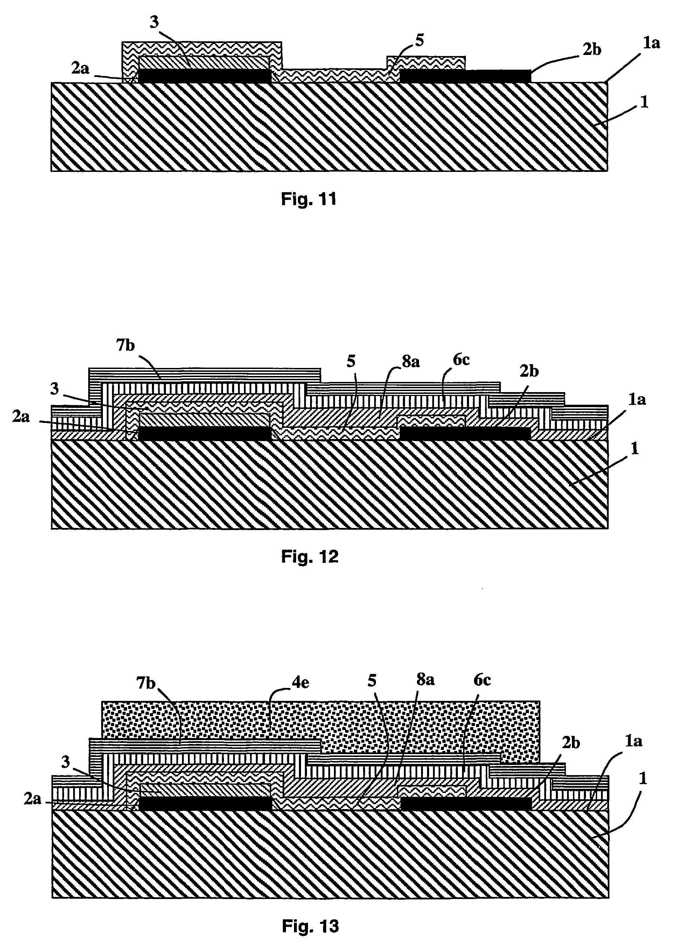

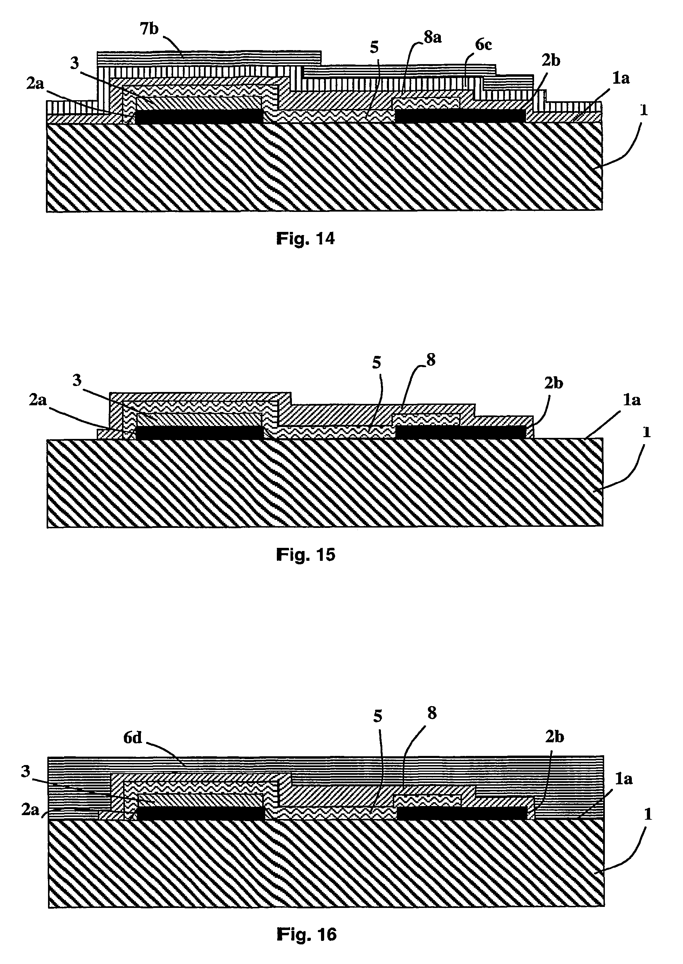

L'anode, le plus souvent constituée par du lithium métallique, peut également être formée par les technologies utilisées dans le domaine de la microélectronique, en utilisant également un double masquage tel que celui utilisé pour former l'électrolyte 5. Ainsi, comme représentée à la figure 11, la seconde couche de protection 6b est retirée pour libérer l'électrolyte 5, la face 1a libre du substrat 1 et la partie libre du seconde collecteur 2b. Une couche mince anodique 8a, de préférence en lithium métallique, est ensuite déposée, de manière homogène, sur la totalité de la face 1a du substrat 1 de sorte que la couche mince anodique 8a recouvre la surface libre du substrat 1, l'électrolyte 5 et la partie libre du second collecteur 2b (figure 12). Une troisième couche mince de protection 6c et une seconde couche mince de masquage 7b sont alors successivement déposées sur la totalité de la couche mince anodique 8a de manière à former un double masquage. La troisième couche mince de protection 6c peut être constituée par le même matériau que la première couche mince de protection tandis que la seconde couche mince de masquage 7b peut être constituée par le même matériau que la première couche de masquage 7a.

Comme pour la formation de l'électrolyte 5, une couche mince en résine photosensible est déposée sur la seconde couche mince de masquage 7b puis elle est photolithographiée pour obtenir un cinquième élément de masquage 4e destiné à définir la forme et la position de la seconde couche mince de masquage 7a lors d'une opération de gravure sélective par plasma de la seconde couche de masquage (figure 14). Puis, la troisième couche de protection 6c et la couche mince anodique 8a sont ensuite gravées sélectivement par plasma à travers la seconde couche de masquage 7b, définissant ainsi la forme finale et la position de l'anode 8. A la figure 8, l'anode 8 recouvre totalement l'électrolyte 5 et le second collecteur 2b. La troisième couche de protection 6c et la seconde couche de masquage 7b sont ensuite retirées pour libérer l'anode 8 (figure 15). La troisième couche de protection 6c est, de préférence, constituée par le même matériau que la première couche de protection 6a tandis que la seconde couche de masquage 7b est, de préférence, constituée par le même matériau que la première couche de masquage 7a.

Une fois la micro-batterie au lithium formée, une quatrième couche de protection 6d peut être disposée sur la totalité de l'empilement formé par les collecteurs de courant 2a et 2b, la cathode 3, l'électrolyte 5 et l'anode 8 (figure 16). La quatrième couche de protection 6d est, de préférence, constituée par le même matériau que la première couche de protection. Ceci permet de réaliser une encapsulation étanche de l'empilement, et notamment de l'anode, les protégeant ainsi contre toute contamination extérieure. Il est alors possible de déplacer ou de stocker à l'air libre la micro-batterie au lithium sans risquer de l'endommager.

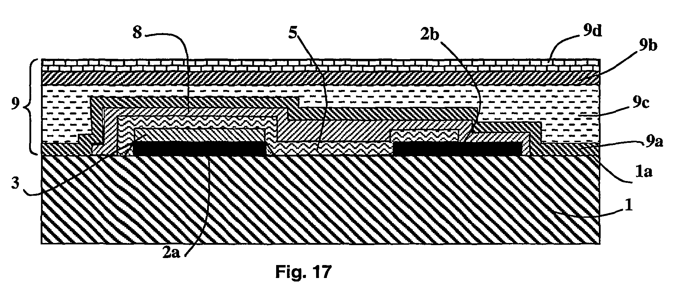

Dans une variante de réalisation illustrée à la figure 17, la quatrième couche de protection peut être remplacée par une enveloppe de protection 9 comportant au moins des première et seconde couches d'encapsulation 9a et 9b superposées et distinctes. Les première et seconde couches d'encapsulation 9a et 9b sont successivement déposées, sur la totalité de l'anode 8, par dépôt chimique en phase vapeur assisté par plasma, à une température de dépôt inférieure ou égale à 150°C. La première couche d'encapsulation 9a comporte au moins un matériau chimiquement inerte par rapport au lithium, choisi parmi un carbure de silicium amorphe hydrogéné, un oxycarbure de silicium amorphe hydrogéné, du carbone amorphe hydrogéné, du carbone amorphe fluoré et du silicium amorphe hydrogène. La seconde couche d'encapsulation 9b comporte un matériau choisi parmi un carbonitrure de silicium amorphe hydrogéné, un nitrure de silicium amorphe hydrogéné et du carbone amorphe fluoré. Il est également possible de déposer, avant le dépôt de la seconde couche d'encapsulation 9b, une couche intermédiaire 9c comportant un matériau choisi parmi un oxyde de silicium dopé au phosphore, du carbone amorphe hydrogéné et du carbone amorphe fluoré, par dépôt chimique en phase vapeur assisté par plasma, à une température de dépôt inférieure ou égale à 150°C. De plus, une couche finale 9c, en carbone amorphe hydrogéné ou en carbone amorphe fluoré, peut également être déposée sur la seconde couche d'encapsulation 9b, par dépôt chimique en phase vapeur assisté par plasma, à une température de dépôt inférieure ou égale à 150°C.

L'invention n'est pas limitée aux modes de réalisation décrits ci-dessus. Ainsi, la technique de double masque peut être employée pour tout élément constitutif de la micro-batterie comportant un composé lithié. A titre d'exemple, si la cathode comporte un composant lithié, elle sera formée de la même manière que l'électrolyte 5, en utilisant une couche de protection et une couche de masquage destinées à la protéger contre toute contamination extérieure et à permettre de réaliser une étape de photolithographie et une gravure. De plus, tout type de gravure connu peut être employé pour former les différents éléments constitutifs de la micro-batterie au lithium. Ainsi, la gravure par plasma peut être remplacée par une gravure sèche.

Ainsi, un tel procédé de fabrication d'une micro-batterie au lithium est compatible avec les technologies mises en oeuvre dans le domaine de la microélectronique, ce qui permet notamment d'incorporer une telle micro-batterie au lithium sur un micro-composant tel qu'un circuit intégré. De plus, contrairement à l'art antérieur dans lequel les éléments constitutifs de la micro-batterie sont formés par dépôt à travers un masque, le fait de pouvoir réaliser les éléments constitutifs de la micro-batterie par gravure empêche des contacts physiques entre un masque et l'élément constitutif. Ceci réduit le risque de rayures sur l'élément constitutif ainsi que d'éventuelles contaminations particulaires et cela apporte également une meilleure reproductibilité, améliorant ainsi les rendements sur un substrat ou de substrat en substrat.

Enfin, le fait de pouvoir utiliser les techniques mises en oeuvre dans le domaine de la microélectronique permet également de réduire les coûts notamment pour une micro-batterie au lithium incorporée sur un circuit intégré, contrairement aux procédés de fabrication selon l'art antérieur dans lesquels la micro-batterie au lithium devait être collée sur un circuit intégré.

## Revendications

1. Procédé de fabrication d'une micro-batterie au lithium comportant successivement la formation, sur un substrat (1), de premier et second collecteurs de courant (2a, 2b), d'une cathode (3), d'un électrolyte (5) comportant un composé lithié et d'une anode (8) comportant du lithium, **caractérisé en ce que** l'étape de formation de l'électrolyte (5) comporte au moins les opérations successives suivantes :
- dépôt d'une couche mince électrolytique (5a) sur le substrat (1) muni des collecteurs de courant (2a, 2b) et de la cathode (3),
- dépôt, sur la couche mince électrolytique (5a), d'une première couche mince de protection (6a) chimiquement inerte par rapport au lithium puis d'u ne première couche mince de masquage (7a),
- réalisation d'un masque (4d) par photolithographie sur la première couche mince de masquage (7a),
- gravure sélective de la première couche mince de masquage (7a) puis retrait du masque (4d),
- gravure sélective de la première couche mince de protection (6a) et de la couche mince électrolytique (5a) de manière à former l'électrolyte (5) dans la couche mince électrolytique (5a) et retrait des premières couches minces de protection (6a) et de masquage (7a).

2. Procédé selon la revendication 1, **caractérisé en ce que** la première couche mince de protection (6a) est constituée par un premier matériau choisi parmi un carbure de silicium amorphe hydrogéné, un oxycarbure de silicium amorphe hydrogéné, un carbonitrure de silicium amorphe hydrogéné, du carbone amorphe hydrogéné, du carbone amorphe fluoré et hydrogéné, un nitrure de carbone amorphe fluoré et hydrogéné.

3. Procédé selon la revendication 2, **caractérisé en ce que** la première couche mince de masquage (7a) est constituée par un second matériau distinct du premier matériau et choisi parmi un carbure de silicium amorphe hydrogéné, un oxycarbure de silicium amorphe hydrogéné, un carbonitrure de silicium amorphe hydrogéné, un nitrure de silicium et un oxyde de silicium.

4. Procédé selon l'une quelconque des revendications 1 à 3, **caractérisé en ce qu'**une fois l'électrolyte (5a) formé, une seconde couche mince de protection (6b) est déposée sur la totalité du substrat (1) comportant les collecteurs de courant (2a, 2b), la cathode (3) et l'électrolyte (5).

5. Procédé selon la revendication 4, **caractérisé en ce que** la seconde couche mince de protection (6b) est constituée par le même matériau que la première couche mince de protection (6a).

6. Procédé selon l'une quelconque des revendications 1 à 5, **caractérisé en ce que** la formation de l'anode (8) comporte au moins les étapes suivantes:
- dépôt d'une couche mince anodique (8a) sur le substrat (1a) muni des collecteurs de courant (2a, 2b), de la cathode (3) et de l'électrolyte (5),
- dépôt d'une troisième couche mince de protection (6c) puis d'une seconde couche mince de masquage (7b) sur la couche mince anodique (5a),
- réalisation d'un masque (4e) par photolithographie sur la seconde couche mince de masquage (7b),
- gravure sélective de la seconde couche mince de masquage (7b) puis retrait du masque (4e),
- gravure sélective de la troisième couche mince de protection (6c) et de la couche mince anodique (8a) de manière à former l'anode (8) dans la couche mince anodique (8a) et retrait des couches minces de protection (6c) et de masquage (7b).

7. Procédé selon la revendication 6, **caractérisé en ce que** la troisième couche mince de protection (6c) est constituée par le même matériau que la première couche mince (6a) de protection (6a) tandis que la seconde couche mince de masquage (7b) est constituée par le même matériau que la première couche mince de masquage (7a).

8. Procédé selon l'une quelconque des revendications 1 à 7, **caractérisé en ce qu'**une fois l'anode (8) formée, il consiste à déposer, sur l'empilement formé par les collecteurs de courant (2a, 2b), la cathode (3), l'électrolyte (5) et l'anode (8), une quatrième couche de protection (6d).

9. Procédé selon la revendication 8, **caractérisé en ce que** la quatrième couche mince de protection (6d) est constituée par le même matériau que la première couche mince de protection (6a).

10. Procédé selon l'une quelconque des revendications 1 à 7, **caractérisé en ce qu'**une fois l'anode (8) formée, il consiste à déposer, sur l'empilement formé par les collecteurs de courant (2a, 2b), la cathode (3), l'électrolyte (5) et l'anode (8), une enveloppe de protection (9) recouvrant la totalité de l'empilement pour le protéger contre toute contamination extérieure.

11. Procédé selon la revendication 10, **caractérisé en ce que** l'enveloppe de protection (9) comportant au moins des première et seconde couches d'encapsulation (9a, 9b) superposées et distinctes, la première couche d'encapsulation (9a) comporte au moins un matériau chimiquement inerte par rapport au lithium, choisi parmi un carbure de silicium amorphe hydrogéné, un oxycarbure de silicium amorphe hydrogéné, du carbone amorphe hydrogéné, du carbone amorphe fluoré et du silicium amorphe hydrogène tandis que la seconde couche d'encapsulation (9b) comporte un matériau choisi parmi un carbonitrure de silicium amorphe hydrogéné, un nitrure de silicium amorphe hydrogéné et du carbone amorphe fluoré, les première et seconde couches d'encapsulation (9a, 9b) étant successivement déposées, sur la totalité de l'anode (8), par dépôt chimique en phase vapeur assisté par plasma, à une température de dépôt inférieure ou égale à 150°C.

12. Procédé selon la revendication 11, **caractérisé en ce qu'**il consiste, avant le dépôt de la seconde couche d'encapsulation (9b), à déposer une couche intermédiaire (9c) comportant un matériau choisi parmi un oxyde de silicium dopé au phosphore, du carbone amorphe hydrogéné et du carbone amorphe fluoré, par dépôt chimique en phase vapeur assisté par plasma, à une température de dépôt inférieure ou égale à 150°C.

## Claims

1. Method for producing a lithium microbattery successively comprising formation of first and second current collectors (2a, 2b), of a cathode (3), of an electrolyte (5) comprising a lithiated compound and of an anode (8) comprising lithium on a substrate (1), **characterized in that** the formation step of the electrolyte (5) comprises at least the following successive operations:
- deposition of an electrolytic thin layer (5a) on the substrate (1) provided with the current collectors (2a, 2b) and with the cathode (3),
- deposition, on the electrolytic thin layer (5a), of a first protective thin layer (6a) that is chemically inert with regard to lithium, and then of a first masking thin layer (7a),
- fabrication of a mask (4d) by photolithography on the first masking thin layer (7a),
- selective etching of the first masking thin layer (7a) then removal of the mask (4d),
- selective etching of the first protective thin layer (6a) and of the electrolytic thin layer (5a) so as to form the electrolyte (5) in the electrolytic thin layer (5a), and removal of the first protective thin layer (6a) and of the first masking thin layer (7a).

2. Method according to claim 1, **characterized in that** the first protective thin layer (6a) consists of a first material chosen from a hydrogenated amorphous silicon carbide, a hydrogenated amorphous silicon oxycarbide, a hydrogenated amorphous silicon carbonitride, hydrogenated amorphous carbon, fluorinated and hydrogenated amorphous carbon, a fluorinated and hydrogenated amorphous carbon nitride.

3. Method according to claim 2, **characterized in that** the first masking thin layer (7a) consists of a second material distinct from the first material and chosen from a hydrogenated amorphous silicon carbide, a hydrogenated amorphous silicon oxycarbide, a hydrogenated amorphous silicon carbonitride, a silicon nitride and a silicon oxide.

4. Method according to any one of the claims 1 to 3, **characterized in that** once the electrolyte (5a) has been formed, a second protective thin layer (6b) is deposited on the whole of the substrate (1) comprising the current collectors (2a, 2b), the cathode (3) and the electrolyte (5).

5. Method according to claim 4, **characterized in that** the second protective thin layer (6b) consists of the same material as the first protective thin layer (6a).

6. Method according to any one of the claims 1 to 5, **characterized in that** formation of the anode (8) comprises at least the following steps:
- deposition of an anodic thin layer (8a) on the substrate (1 a) provided with the current collectors (2a, 2b), the cathode (3) and the electrolyte (5),
- deposition of a third protective thin layer (6c) and then of a second masking thin layer (7b) on the anodic thin layer (5a),
- fabrication of a mask (4e) by photolithography on the second masking thin layer (7b),
- selective etching of the second masking thin layer (7b) then removal of the mask (4e),
- selective etching of the third protective thin layer (6c) and of the anodic thin layer (8a) so as to form the anode (8) in the anodic thin layer (8a) and removal of the protective thin layer (6c) and masking thin layer (7b).

7. Method according to claim 6, **characterized in that** the third protective thin layer (6c) consists of the same material as the first protective thin layer (6a) whereas the second masking thin layer (7b) consists of the same material as the first masking thin layer (7a).

8. Method according to any one of the claims 1 to 7, **characterized in that** once the anode (8) has been formed, it consists in depositing a fourth protective layer (6d) on the stack formed by the current collectors (2a, 2b), the cathode (3), the electrolyte (5) and the anode (8).

9. Method according to claim 8, **characterized in that** the fourth protective thin layer (6d) consists of the same material as the first protective thin layer (6a).

10. Method according to any one of the claims 1 to 7, **characterized in that** once the anode (8) has been formed, it consists in depositing, on the stack formed by the current collectors (2a, 2b), the cathode (3), the electrolyte (5) and the anode (8), a protective envelope (9) covering the whole of the stack to protect the latter against any external contamination.

11. Method according to claim 10, **characterized in that** the protective envelope (9) comprising at least first and second distinct superposed encapsulation layers (9a, 9b), the first encapsulation layer (9a) comprises at least one material that is chemically inert with regard to lithium, chosen from a hydrogenated amorphous silicon carbide, a hydrogenated amorphous silicon oxycarbide, hydrogenated amorphous carbon, fluorinated amorphous carbon and hydrogenated amorphous silicon whereas the second encapsulation layer (9b) comprises a material chosen from a hydrogenated amorphous silicon carbonitride, a hydrogenated amorphous silicon nitride and fluorinated amorphous carbon, the first and second encapsulation layers (9a, 9b) being successively deposited on the whole of the anode (8) by plasma enhanced chemical vapor deposition at a deposition temperature less than or equal to 150°C.

12. Method according to claim 11, **characterized in that** it consists, before deposition of the second encapsulation layer (9b), in depositing an intermediate layer (9c) comprising a material chosen from a phosphorus-doped silicon oxide, hydrogenated amorphous carbon and fluorinated amorphous carbon by plasma enhanced chemical vapor deposition at a deposition temperature less than or equal to 150°C.

## Patentansprüche

1. Herstellungsverfahren für eine Lithium-Mikrobatterie, das nacheinander die Ausbildung eines ersten und eines zweiten Stromkollektors (2a, 2b), einer Kathode (3), eines eine lithiumhaltige Verbindung enthaltenden Elektrolyten (5) und einer Lithium umfassenden Anode (8) auf einem Substrat (1) umfasst, **dadurch gekennzeichnet, dass** der Herstellungsvorgang des Elektrolyten (5) mindestens folgende aufeinanderfolgende Schritte umfasst:
- Aufbringen einer dünnen elektroytischen Schicht (5a) auf das mit den Stromkollektoren (2a, 2b) und der Kathode (3) bestückte Substrat (1),
- Aufbringen einer ersten dünnen, gegenüber dem Lithium chemisch inerten Schutzschicht (6a) auf die dünne elektrolytische Schicht (5a) und anschließend einer ersten dünnen Maskierungsschicht (7a),
- Herstellung einer Maske (4a) durch Fotolithografie auf der ersten dünnen Maskierungsschicht (7a),
- selektives Ätzen der ersten dünnen Maskierungsschicht (7a), dann Entfernen der Maske (4d),
- selektives Ätzen der ersten dünnen Schutzschicht (6a) und der dünnen elektrolytischen Schicht (5a), um in der dünnen elektrolytischen Schicht (5a) den Elektrolyten (5) auszubilden, und Entfernen der ersten dünnen Schutzschicht (6a) und der ersten dünnen Maskierungsschicht (7a).

2. Verfahren nach Anspruch 1, **dadurch gekennzeichnet, dass** die erste dünne Schutzschicht (6a) aus einem ersten Material besteht, das aus einem hydrierten amorphen Siliziumkarbid, einem hydrierten amorphen Siliziumoxykarbid, einem hydrierten amorphen Siliziumkarbonitrid, hydriertem amorphen Kohlenstoff, fluoriertem und hydriertem amorphen Kohlenstoff oder einem fluorierten oder hydrierten amorphen Kohlenstoff nitrid ausgewählt ist.

3. Verfahren nach Anspruch 2, **dadurch gekennzeichnet, dass** die erste dünne Maskierungsschicht (7a) aus einem zweiten Material besteht, das sich vom ersten Material unterscheidet und aus einem hydrierten amorphen Siliziumkarbid, einem hydrierten amorphen Siliziumoxykarbid, einem hydrierten amorphen Siliziumkarbonitrid, einem Siliziumnitrid oder einem Siliziumoxyd ausgewählt ist.

4. Verfahren nach einem der Ansprüche 1 bis 3, **dadurch gekennzeichnet, dass** nach der Herstellung des Elektrolyten (5) eine zweite dünne Schutzschicht (6b) auf das komplette Substrat (1) aufgebracht wird, das die Stromkollektoren (2a, 2b), die Kathode (3) und den Elektrolyten enthält (5).

5. Verfahren nach Anspruch 4, **dadurch gekennzeichnet, dass** die zweite Schutzschicht (6d) aus dem gleichen Material wie die erste Schutzschicht (6a) besteht.

6. Verfahren nach einem der Ansprüche 1 bis 5, **dadurch gekennzeichnet, dass** die Ausbildung der Anode (8) mindestens folgende Schiritte umfasst :
- Aufbringen einer dünnen elektroytischen Schicht (8a) auf das mit den Stromkollektoren (2a, 2b), der Kathode (3) und dem Elektrolyten (5) bestückte Substrat (1),
- Aufbringen einer dritten dünnen Schutzschicht (6c) und dann einer zweiten dünnen Maskierungsschicht (7b) auf die dünne anodische Schicht (5a),
- Herstellung einer Maske (4e) durch Fotolithografie auf der zweiten dünnen Maskierungsschicht (7b),
- selektives Ätzen der zweiten dünnen Maskierungsschicht (7b), dann Entfernen der Maske (4e),
- selektives Ätzen der dritten dünnen Schutzschicht (6c) und der dünnen anodischen Schicht (8a), um in der dünnen anodischen Schicht (8a) die Anode (8) auszubilden, und Entfernen der dünnen Schutzschicht (6c) und der dünnen Maskierungsschicht (7b).

7. Verfahren nach Anspruch 6, **dadurch gekennzeichnet, dass** die dritte dünne Schutzschicht (6c) aus dem gleichen Material wie die erste dünne Schutzschicht (6a) besteht, während die zweite dünne Maskierungsschicht (7b) aus dem gleichen Material wie die erste dünne Maskierungsschicht (7a) besteht.

8. Verfahren nach einem der Ansprüche 1 bis 7, **dadurch gekennzeichnet, dass**, nachdem die Anode (8) hergestellt ist, es darin besteht, eine vierte Schutzschicht (6d) auf die von den Stromkollektoren (2a, 2b), der Kathode (3), dem Elektrolyten (5) und der Anode (8) gebildeten Schichtung aufzubringen.

9. Verfahren nach Anspruch 8, **dadurch gekennzeichnet, dass** die vierte dünne Schutzschicht (6d) aus dem gleichen Material wie die erste dünne Schutzschicht (6a) besteht.

10. Verfahren nach einem der Ansprüche 1 bis 7, **dadurch gekennzeichnet, dass**, nachdem die Anode (8) hergestellt ist, es darin besteht, auf die von den Stromkollektoren (2a, 2b), der Kathode (3), dem Elektrolyten (5) und der Anode (8) gebildeten Schichtung eine Schutzhülle (9) aufzubringen, die die ganze Schichtung bedeckt, um sie gegen jegliche äußere Verunreinigung zu schützen.

11. Verfahren nach Anspruch 10, **dadurch gekennzeichnet, dass**, nachdem die Schutzhülle (9) mindestens eine erste und eine zweite Verkapselungshülle (9a, 9b) umfasst, die übereinander angeordnet und voneinander verschieden sind, die erste Verkapselungsschicht (9a) mindestens ein gegenüber dem Lithium chemisch inertes Material, das aus einem hydrierten amorphen Siliziumkarbid, einem hydrierten amorphen Siliziumoxykarbid, hydriertem amorphen Kohlenstoff, fluoriertem amorphen Kohlenstoff oder hydriertem amorphen Silizium ausgewählt ist, umfasst, während die zweite Verkapselungsschicht (9b) ein Material umfasst, das aus einem hydrierten amorphen Siliziumkarbonitrid, einem hydrierten amorphen Siliziumnitrid oder fluoriertem amorphen Kohlenstoff ausgewählt ist, wobei die erste und zweite Verkapselungsschicht (9a, 9b) bei einer Aufdampftemperatur von unter oder gleich 150°C durch plasmaunterstützte Gasphasenabscheidung nacheinander auf die gesamte Anode (8) aufgedampft werden.

12. Verfahren nach Anspruch 11, **dadurch gekennzeichnet, dass** es darin besteht, vor dem Aufdampfen der zweiten Verkapselungsschicht (9b) eine Zwischenschicht (9c) aufzudampfen, die ein Material enthält, das aus phosphordotiertem Siliziumoxyd, hydrierten amorphen Kohlenstoff oder fluoriertem amorphen Kohlenstoff ausgewählt ist, und zwar durch plasmaunterstützte Gasphasenabscheidung bei einer Aufdampftemperatur von unter oder gleich 150°C.
